# EUROPÄISCHE PATENTSCHRIFT

(11) **EP 0 922 322 B1**
(45) Veröffentlichungstag und Bekanntmachung des Hinweises auf die Patenterteilung: **15.03.2000**
(21) Anmeldenummer: 97950011.3
(22) Anmeldetag: 29.08.1997
(51) Int. Cl.: H02J 5/00

(54) **NETZGERÄT**
POWER BACK
BLOC D'ALIMENTATION SECTEUR

(30) Priorität: 29.08.1996 DE 19634948
(43) Veröffentlichungstag der Anmeldung: 16.06.1999
(73) Patentinhaber: Interessengemeinschaft für Rundfunkschutzrechte GmbH Schutzrechtsverwertung & Co. KG., D-40210 Düsseldorf (DE)
(72) Erfinder: KRAUS, Heinz, D-96328 Küps (DE)
(74) Vertreter: Eichstädt, Alfred, Dipl.-Ing.
(86) Internationale Anmeldenummer: EP9704721
(87) Internationale Veröffentlichungsnummer: WO9809362

(56) Entgegenhaltungen:
- WO-A-95/23450
- DE-A- 2 642 267
- FR-A- 2 699 024

## Beschreibung

Die Erfindung betrifft ein Netzgerät, das einen Anschluß an ein Wechselspannung führendes Stromversorgungsnetz und einen Gleichstromausgang aufweist. Der Ausgang kann dabei ein Kabel, an dessen Ende ein Stecker zum Einführen in eine Stromversorgungsbuchse eines anzuschließenden Gerätes vorgesehen ist, oder eine Anschlußbuchse sein, die Bestandteil des Netzgerätes ist und in die ein Steckverbinder eines anzuschließenden Gerätes einsteckbar ist. Das Netzgerät kann darüber hinaus als sogenanntes Steckernetzteil ausgebildet und direkt in eine Netzsteckdose eingesetzt sein. Das Netzteil kann aber auch als abgesetztes Teil ausgebildet und beispielsweise über ein Netzkabel mit dem Stromversorgungsnetz verbindbar sein. Die Erfindung umfaßt darüber hinaus ein Netzgerät, das in Schaltungsplatinenausführung in einen Stromverbraucher einsetzbar ist.

Ein Netzgerät mit Einweggleichrichter oder Vollweggleichrichter oder sonstigen Gleichrichterschaltungen ist z. B. aus dem Fachbuch "Halbleiterschaltungsrechnik", 3. Auflage, Seite 29 ff., von U. Tietze und Ch. Schenk bekannt.

Aus der WO-A-9.523.450 ist ferner eine automatische Ausschalteinrichtung bekannt, die einen Anschluß an ein Wechselspannung führendes Stromversorgungsnetz, zwei elektronische Schaltelemente in den beiden Leitungen des Primärstromkreises, einen Transformator und eine nachgeschaltete Gleichrichterschaltung zur Versorgung eines Verbrauchers aufweist. Zur Steuerung der elektronischen Schaltelemente ist eine Sekundärstromversorgung für eine Steuerschaltung für die beiden elektronischen Schaltelemente vorgesehen. Die Stromversorgung der Steuerschaltung ist bei abgeschaltetem Verbraucher hierüber sichergestellt.

Im Normalbetrieb wird die Stromversorgung über eine Stromversorgungsschaltung von der Sekundärseite des Primärstromkreises versorgt. Die elektronischen Schaltelemente in dem Primärstromkreis werden nicht automatisch leitend geschaltet, wenn die Last eingeschaltet oder angekoppelt wird. Die Ansteuerung erfolgt über gesonderte, manuell zu betätigende Schalter, die mit der Steuerschaltung zusammenwirken.

Moderne Kleingeräte, insbesondere Kleingeräte im Haushaltsbereich, wie Unterhaltungselektronikgeräte, Uhren, Telefone und dergleichen, weisen in der Regel ein separates Netzgerät auf, das das Gerät mit Gleichstrom versorgt. Dieses Netzgerät, auch als Steckernetzteil bezeichnet, ist mit einem bekannten Netzstecker versehen, der in eine Netzsteckdose bekannter Art einsteckbar ist. Bei anderen Ausführungen, beispielsweise bei Diktiergeräten, Druckern und dergleichen, sind zur Verlängerung ein Zuführungskabel mit Netzanschlußstecker und ein längeres Ausgangskabel zum Kontaktieren des mit Strom zu versorgenden Diktiergerätes vorgesehen. Bei allen Lösungen weist das Netzgerät einen Transformator auf, dessen Sekundärwicklung mit einer Gleichrichterschaltung, bestehend aus einem Brückengleichrichter oder einem Einweggleichrichter mit nachgeschaltetem Elektrolytkondensator zur Siebung der Gleichspannung, verbunden ist. Andere Ausführungen sehen darüber hinaus eine der Gleichrichterschaltung nachgeschaltete Spannungskonstanthalteschaltung bekannter Art vor. Von den Ausgängen bzw. von dem angeschlossenen Kabel ist sodann der Strom abnehmbar, der für die Stromversorgung des anzuschließenden Gerätes erforderlich ist. Derartige angeschlossene Geräte weisen in der Regel auch einen Ein/Ausschalter auf bzw. läßt sich die Stromversorgung unterbrechen, indem der Gleichstromstecker oder Netzstecker gezogen wird.

Es hat sich gezeigt, daß selbst dann, wenn die angeschlossenen Geräte abgeschaltet sind, die Steckernetzteile, aber auch in der anderen angegebenen Bauform ausgelegte Steckernetzgeräte, eine relativ hohe Verlustleistung im nichtbelasteten Zustand aufweisen. Diese betragen bei üblichen Netzgeräten für Kleingeräte z.B. ca. 8 bis 10 W. Die Verlustleistung ist durch die dauernd an das Netz angeschlossene Primärwicklung des Netztransformators stets gegeben.

Eine Netzanschlußschaltung ist aus der DE 41 40 357 A1, Figur 1a, bekannt. Ferner ist aus der DE 39 09 064 C2 ein Netzfreischalter zur Abtrennung von elektrischen Leitungen und Verbrauchern von der Netzwechselspannung bekannt, bei der Phase und Nulleiter der Netzzuleitung in Bezug auf die Ableitung durch jeweils einen elektrisch betätigbaren Kontakt getrennt werden und weiterhin ein Meßkreis vorgesehen ist, der einen Stromverbrauch im Netz erfaßt und die Kontakte solange geschlossen hält, wie der Stromverbrauch anhält. Im Falle des Einschaltens eines angeschlossenen Stromverbrauchers in der Wechselspannung führenden Leitung wird dies von einem Komparator erfaßt, der über eine eine Anzugsverzögerung bewirkende Verzögerungsschaltung das Relais mit den Kontakten im Wechselstromleitungsnetz ansteuert. Zur Erzeugung der Prüfgleichspannung ist dabei ein gesondertes Netzteil vorgesehen, das mittels eines Transformators an der Wechselstrom führenden Leitung angeschlossen ist. Durch das Vorsehen zweier Schaltkontakte, die in Abhängigkeit vom Verbraucher geschlossen oder umgeschaltet werden, wird eine vollständige Potentialfreiheit des abgeschalteten Netzes erreicht.

Der Erfindung liegt die Aufgabe zugrunde, die eingangs genannten Netzgeräte so auszulegen, daß diese dann, wenn keine Last anliegt, vom Netz automatisch getrennt werden und die Verlustleistung wesentlich reduziert wird und mit Anschalten bzw. Verbinden mit Verbrauchern wieder automatisch sicher einschalten. In einer weiteren Ausgestaltungsform soll eine automatische Ab- und Anschaltung auch dann möglich sein, wenn ein angeschlossener Verbraucher im Standby-Betrieb über eine bestimmte Zeitdauer mit Strom versorgt wird.

Die Erfindung löst die Aufgabe durch Ausgestaltung eines Netzgerätes mit den im Anspruch 1 angegebenen Merkmalen.

Vorteilhafte Weiterbildungen des Netzgerätes sind in den Unteransprüchen im einzelnen beschrieben, wobei Anspruch 17 die Lösung angibt, die es ermöglicht, daß die Netztrennung bzw. das Abschalten vom Stromversorgungsnetz auch dann gewährleistet ist, wenn das angeschlossene mit Strom zu versorgende Gerät über einen bestimmten Zeitraum im Standby-Betrieb betrieben wird.

Ein wesentliches Merkmal der Erfindung besteht darin, daß bei abgeschaltetem Transformator das Hilfsnetzteil kapazitiv an den Wechselstromversorgungseingang angekoppelt bleibt, wobei der Stromverbrauch vernachlässigbar gering ist. Dieses Hilfsnetzteil, das sowohl als AC/DC-Netzteil als auch als DC/DC-Netzteil ausgebildet sein kann, liefert den Zündstrom bzw. den Steuerstrom für einen elektronischen Schalter, der in Reihe mit der Primärwicklung des Transformators im Netzgerät geschaltet ist und die Primärwicklung vom Netzstrom trennt bzw. diese anschaltet. Der Strom wird dabei in Abhängigkeit von dem angeschalteten Verbraucher bzw. einer Last in seiner Höhe bestimmt. Im Falle, daß das Gerät abgeschaltet ist oder die Verbindungsbuchse aus dem Stromversorgungseingang des anzuschließenden Gerätes herausgezogen ist, fließt praktisch kein Strom, wodurch der Schalter im Primärkreis den Stromfluß sperrt bzw. geöffnet ist. Liegt eine Last am Ausgang an, so zieht diese Strom aus dem Hilfsnetzteil, der bei entsprechender Dimensionierung der Schaltung ausreichend groß ist, um den Schalter einzuschalten, wodurch die Primärwicklung des Transformators an das Wechselstromnetz angeschlossen wird. Im Falle, daß eine Spannungsstabilisierungsschaltung zur Spannungsstabilisierung der Zündspannung vorgesehen ist, wird der benötigte Steuerstrom durch die Spannungsdifferenz zwischen der Hilfsspannung und der Ausgangsspannung bestimmt. Diese Schaltung hat gegenüber der vorherbeschriebenen den Vorteil, daß stets ein konstanter Steuerstrom fließt, um die Einschaltung des Schalters in der Stromzuführungsleitung der Primärwicklung des Transformators zu ermöglichen.

Das Netzgerät nach der Erfindung hat ferner den Vorteil, daß dann, wenn ein Verbraucher ausgeschaltet wird, die Leistungsaufnahme wesentlich reduziert wird, ja auf einen zu vernachlässigenden Betrag sich mindert (< 0,5 W). Das Hilfsnetzteil stellt in diesem Zustand einen kapazitiven Verbraucher dar.

Die Erfindung wird nachfolgend anhand der in den Figuren in der Zeichnung vereinfacht dargestellten Stromlaufpläne von Ausführungsbeispielen ergänzend erläutert.

In den Zeichnungen zeigen:
- Fig. 1: einen Stromlaufplan mit den erfindungswesentlichen Elementen mit einem vereinfacht dargestellten Hilfsnetzteil,
- Fig. 2: einen Stromlaufplan einer erfindungsgemäßen Schaltungsanordnung mit einer besonderen Ausgestaltung einer Anschlußbuchse zum Anschließen eines Steckverbinders eines Verbrauchers sowie eines detaillierter dargestellten Hilfsnetzteils und
- Fig. 3: eine vorteilhafte Weiterbildung des in der Figur 1 gezeigten Ausführungsbeispiels

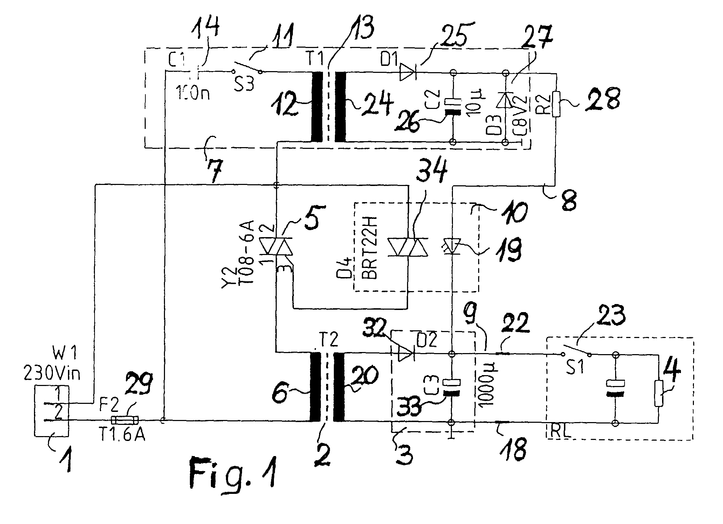

Das in Fig. 1 dargestellte Netzgerät besteht im wesentlichen aus einem Netzanschluß 1, der an ein Stromversorgungsnetz, z.B. ein 230 V Wechselstromnetz, anschließbar ist. Der Anschluß an andere Spannungen führende Netze, wie 110 V, ist ebenfalls möglich, wenn die Schaltung entsprechend ausgelegt ist. Der eine Pol des Netzanschlusses ist über einen Triac 5 mit einer Primärwicklung 6 eines Netztransformators 2 verbunden, dessen anderer Ausgang über eine Sicherung 29 am zweiten Pol des Netzeingangs anliegt. Der Netztransformator 2 weist eine Sekundärwicklung 20 auf, die mit einer Gleichrichterschaltung 3, bestehend aus einem Gleichrichter 32 und einem Elektrolytkondensator 33 als Siebkondensator, verbunden ist, von dem eine Gleichspannung abgreifbar ist. Der Verbindungspunkt zwischen dem Einweggleichrichter 32 und dem Kondensator 33 ist mit der Leitung 9 verbunden, von der die Gleichspannung mit positivem Potential abgreifbar ist. Die beiden Leitungen der Gleichrichteranordnung 3 führen zu den sekundärseitigen Ausgängen 22, 18, an denen Buchsen vorgesehen sind, bzw. gehen sie in ein Anschlußkabel über, das zur direkten Stromversorgung eines Verbrauchers 4 vorgesehen sein kann. Bei bekannten Steckernetzgeräten ist dieses Kabel z. B. mit einem Rundstecker abgeschlossen, dessen Außenhülse Minuspotential und dessen Mittensteckkontakt Pluspotential führt und in eine entsprechende Buchse des Gerätes eingesteckt werden kann. Der Verbraucher 4 weist einen Schalter 23 auf, mit dem er von der Gleichspannungsquelle abgeschaltet bzw. an diese angeschaltet werden kann.

Mit dem einen Pol des Wechselstromnetzes ist ein Hilfsnetzteil 7 verbunden, das im wesentlichen einen Kondensator 14 aufweist, zu dem in Reihe ein elektronischer Schalter 11, z. B. als Bestandteil eines Schaltnetzteils, angeordnet sein kann, und der in Reihe zu der Primärwicklung 12 des Hilfstransformators 13 liegt. Der zweite Anschluß der Primärwicklung 12 liegt am zweiten Pol des Wechselstromnetzes, das über die Sicherung 29 gegen Stromüberlastung geschützt ist. Die Sekundärwicklung 24 des Hilfstransformators 13 ist mit einer Gleichrichterschaltung verbunden, die im wesentlichen aus einer Diode 25 und einem Siebkondensator 26, zu dem parallel ein Spannungsstabilisator 27 geschaltet ist, besteht, so daß eine stabilisierte Gleichspannung an der Leitung 8 anliegt. Diese stabilisierte Gleichspannung liegt an einem Strombegrenzungswiderstand 28 an, der mit der Fotodiode 19 eines Optotriacs 10 gekoppelt ist, dessen Katode an dem Plusspannung führenden Gleichstromanschluß 9 anliegt. Dieser Strombegrenzungswiderstand 28 und der Widerstand 4 des Verbrauchers bestimmen den durch die Fotodiode 19 des Optotriacs fließenden Steuerstrom. Liegt kein Verbraucher an, d.h. ist der Schalter 23 geöffnet, so fließt kein Strom. Wird hingegen der Verbraucher eingeschaltet, also der Schalter 23 geschlossen, so ist der Stromweg über den Verbraucher gegen Masse geschlossen. Es fließt dabei ein ausreichender Steuerstrom, der die Diode aufleuchten läßt. Die Fotodiode steuert den Triac 34 des Optotriacs 10, der als Zündschalter für den Triac 5 als Schalter im Primärkreis des Netztransformators eingeschaltet ist. Dazu ist der Zündanschluß des Triacs 5 mit der einen Anode des Triacs 34 verbunden, dessen andere Anode am Wechselstromeingang liegt.

Der Steuerstrom i_{zünd} für die Diode und die Schaltungsanordnung müssen so bemessen sein, daß die Hilfsspannung einen konstanten Betrag zuzüglich der Ausgangsgleichspannung aufweist. Es ist ersichtlich, daß in Abhängigkeit vom Anliegen des Verbrauchers der benötigte Strom zur Zündung des Triacs fließt bzw. im abgeschalteten Zustand kein Strom fließt, so daß dann nur eine sehr geringe Leistungsaufnahme durch das Hilfsnetzteil erfolgt, das durch die C-Kopplung einen kapazitiven Verbraucher darstellt.

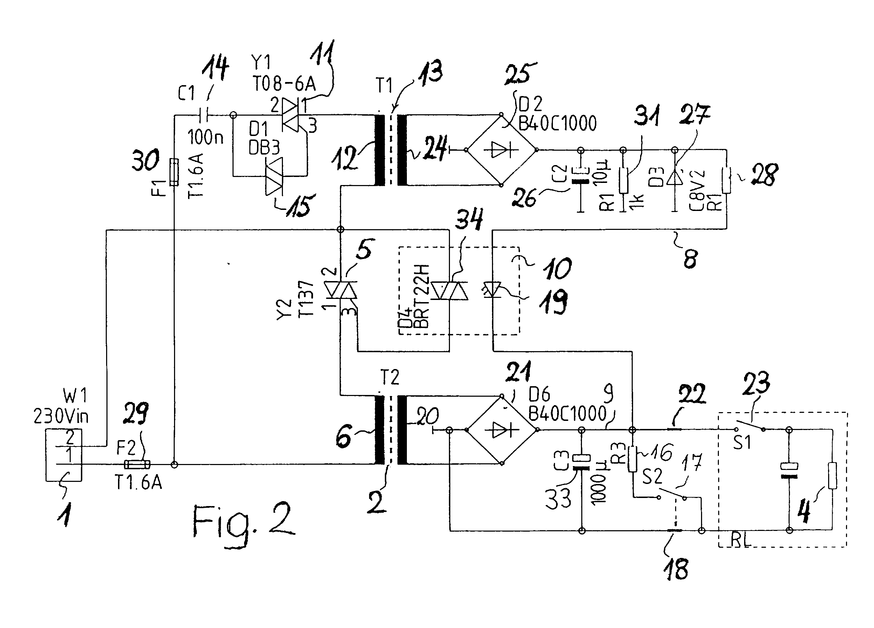

Das Ausführungsbeispiel in Fig. 2 unterscheidet sich nur an wenigen Stellen von dem Ausführungsbeispiel in Fig. 1. Es sind deshalb die Bezugszeichen übernommen worden, soweit sie die gleichen Bauelemente kennzeichnen. So weist das Netzgerät ebenfalls einen Anschluß 1 für den Anschluß an einem Stromversorgungsnetz auf, einen Triac 5, eine Primärwicklung des Netztransformators 2, dessen Sekundärwicklung in einer Gleichrichterschaltung, bestehend aus einem Brückengleichrichter 21 und einem Ladekondensator 33, besteht. Dieser Schaltung kann eine Stabilisierungsschaltung nachgeschaltet sein, damit am Ausgang eine stabilisierte Ausgangsspannung anliegt. Die Leitung 9 ist mit einer Buchse 22 verbunden. Der zweite Buchsenkontakt 18 ist auf Masse gelegt und weist zudem ein durch den Steckkontakt betätigbaren Schalter 17 auf, über den ein Nebenschluß mit einem hochohmigen Widerstand 16 ein- bzw. abschaltbar ist. Durch Einführen der Stecker des Verbrauchers 4 wird der Schalter 17 geschlossen, und es fließt über den Nebenschluß 16 ein konstanter Strom, der auch dann fließt, wenn der Verbraucher über seinen Betriebsschalter 23 ausgeschaltet ist. Das Gerät kann darüber im Standby-Betrieb betrieben werden. Es ist sichergestellt, daß von dem Hilfsnetzteil, dort bestehend aus einem Triac 11 gekoppelt mit einem Diac 15, die den elektronischen Schalter bilden und in Reihe mit der Primärwicklung des Hilfstransformators 12 geschaltet sind, ebenfalls ein Zündstrom fließt oder dieser unterbrochen ist. Die Sekundärwicklung 24 ist mit einem Brückengleichrichter 25 verbunden, dessen Ausgang mit einem Siebkondensator 26 gekoppelt ist, zu dem parallel ein Widerstand 31 und eine Stabilisierungsschaltung 27 gegen Masse geschaltet sind. Der benötigte Steuerstrom wird über den Strombegrenzungswiderstand 28 und die Leitung 8 der Fotodiode 19 des Optotriacs 10 zugeleitet, der im übrigen die gleiche Funktion besitzt wie im Ausführungsbeispiel nach Fig. 1. Die Besonderheit dieser Schaltung liegt darin, daß dieses Netzteil auch im Standby-Betrieb gefahren werden kann, indem über den Nebenschluß 16 zwangsweise die Primärwicklung des Netztransformators 6 eingeschaltet wird, so daß am Ausgang eine Spannung zur Verfügung steht, um beispielsweise über einen Timer den Schalter 17 steuern zu können, der mechanisch steuerbar oder aber auch als elektronischer Schalter ausgeführt und abhängig oder unabhängig von der mechanischen Betätigung bei der Zusammenführung steuerbar sein kann. Über einen Timer wäre es praktisch möglich, das Gerät aus dem Standby-Zustand automatisch in den Aus-Zustand zu schalten, indem der Schalter 17 öffnet, wodurch kein Steuerstrom mehr durch die Fotodiode 19 fließt. Andererseits kann, wenn keine Timerfunktion eingeschaltet oder kein Timer vorgesehen ist, erreicht werden, daß der Verbraucher im Standby-Betrieb gefahren wird, beispielsweise wenn der Verbraucher ein Satellitenempfänger ist, können die Fernsehsignale an ein Aufzeichnungsgerät abgegeben werden. Es ist weiterhin möglich, den Betriebsschalter 23 so auszubilden, daß er eine elektronische Steuerfunktion für den Schalter 17 ausübt, so daß über diesen der Standby-Betrieb ein- und ausgeschaltet werden kann anstelle oder ergänzend zu einer Timerfunktion.

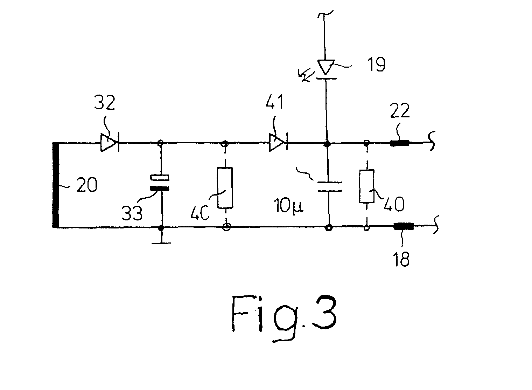

Bei der Schaltung nach Figur 1 kann gemäß einer vorteilhaften, in der Figur 3 gezeigten Weiterbildung der Erfindung parallel zum Kondensator 33 ein Ohmscher Widerstand 40 und zwischen dem massenfernen Ende dieses Widerstandes 40 und dem Ausgang 22 eine weitere Diode 41 angeordnet sein, deren Kathode über einen weiteren Kondensator 42 auf Masse liegt.

Alternativ oder zusätzlich zum Widerstand 40 ist weiterhin ein Widerstand 40' parallel zum Kondensator 42 vorgesehen. Diese Maßnahmen sorgen im Leerlaufzustand dafür, daß sich an dem bzw. den Kondensatoren 33 bzw. 42 keine unzulässig hohe(n) Spannung(en) aufbauen kann(können). Es versteht sich, daß der Widerstand 40' so zu dimensionieren ist, daß noch kein zum Aufleuchten der Diode 19 ausreichender Steuerstrom i_{zünd} fließt.

## Patentansprüche

1. Netzgerät, aufweisend einen Anschluß (1) an ein Wechselspannung führendes Stromversorgungsnetz mit mindestens einem Transformator (2), einer nachgeschalteten Gleichrichterschaltung (3), an die ein Verbraucher (4) anschließbar ist und einen elektronischen Schalter (5) in der Stromzuführungsleitung der Primärwicklung (6) des Transformators (2) und ein kapazitiv an die Stromzuführungsleitung des Netzgerätes angeschlossenes Hilfsnetzteil (7), dadurch gekennzeichnet, daß
- das Hilfsnetzteil (7) ein Schaltnetzteil mit einer Selbstschwingschaltung ist,
- wobei am Ausgang des Hilfsnetzteils (7) eine Steuerspannung für den elektronischen Schalter (5) abgreifbar ist, die höher ist als die unter Last am Ausgang des Netzgerätes anliegende Spannung und
- wobei die Potential führende Ausgangsleitung (8) des Hilfsnetzteils mit der Potential führenden Leitung (9) auf der Sekundärseite des Transformators (2) des Netzgerätes verbunden ist, und
- im Falle der Belastung durch einen Verbraucher (4) aus dem Hilfsnetzteil (7) Strom entnommen wird, wodurch ein strom- und/oder spannungsabhängig arbeitendes Steuerelement (10) ein Steuersignal für den elektronischen Schalter (5) in der Stromzuführungsleitung der Primärwicklung (6) des Transformators (2) im Netzgerät generiert.

2. Netzgerät nach Anspruch 1, dadurch gekennzeichnet, daß als Schaltelement der Selbstschwingschaltung ein Triac (11) mit einem parallelen Zündhalbleiter (15) in Reihe mit der Primärwicklung (12) eines Hilfstransformators (13) und einem vorgeschalteten Kondensator (14) vorgesehen ist, der mit einer Phase des Stromversorgungsnetzes verbunden ist, während das andere Ende der Primärwicklung an der anderen Phase liegt.

3. Netzgerät nach einem der vorhergehenden Ansprüche, dadurch gekennzeichnet, daß der angeschlossene Verbraucher (4) das Hilfsnetzteil (7) im angeschlossenen und eingeschalteten Zustand mit einem Strom bestimmter Stärke zur Aufrechterhaltung des Schließzustandes des Schalters (5) belastet.

4. Netzgerät nach einem der vorhergehenden Ansprüche, dadurch gekennzeichnet, daß ein hochohmiger Nebenschluß (16) mit einem Schaltelement (17) zwischen den potential- und massepotentialführenden sekundärseitigen Ausgängen (18, 22) vorgesehen ist.

5. Netzgerät nach Anspruch 4, dadurch gekennzeichnet, daß das Schaltelement (17) in eine Anschlußbuchse (18) für die Kopplung mit dem Verbraucher (4) integriert ist und beim Schließen der Steckverbindung den Widerstand (16) im Nebenschluß einschaltet und beim Öffnen ausschaltet.

6. Netzgerät nach einem der vorhergehenden Ansprüche, dadurch gekennzeichnet, daß das Hilfsnetzteil (7) kapazitiv einphasig an die Stromzuführungsleitung des Netzgerätes angeschlossen ist.

7. Netzgerät nach einem der vorhergehenden Ansprüche, dadurch gekennzeichnet, daß das Hilfsnetzteil (7) ein DC/DC-Wandler ist und daß in Reihe mit dem Kondensator (14) eine Diode oder Diodenanordnung zur Gleichrichtung der anliegenden Netzspannung beziehungsweise einer geteilten Netzspannung geschaltet ist.

8. Netzgerät nach einem der Ansprüche 1 bis 6, dadurch gekennzeichnet, daß das Hilfsnetzteil (7) ein AC/DC-Wandler ist.

9. Netzgerät nach Anspruch 7, dadurch gekennzeichnet, daß das Hilfsnetzteil (7) einen Brückengleichrichter aufweist, der über zwei Kondensatoren an die beiden Phasen des Stromversorgungsnetzes angeschlossen ist.

10. Netzgerät nach Anspruch 1, dadurch gekennzeichnet, daß das Steuerelement (10) ein Opto-Triac ist, wobei durch eine Leuchtdiode (19) der sekundärseitige Strom des Hilfsnetzteils (7) fließt, die den zugeordneten Triac (34) steuert.

11. Netzgerät nach Anspruch 1, dadurch gekennzeichnet, daß der Schalter (5) ein elektronischer Halbleiterschalter ist.

12. Netzgerät nach Anspruch 10 und 11, dadurch gekennzeichnet, daß der Schalter (5) ein Triac ist, der von dem Opto-Triac (10) angesteuert wird.

13. Netzgerät nach einem der vorhergehenden Ansprüche, dadurch gekennzeichnet, daß das Netzgerät mit seinen Schaltungskomponenten eine bauliche Einheit eines in eine Steckdose eines Stromversorgungsnetzes einsteckbaren Netzgerätes ist.

14. Netzgerät nach einem der Ansprüche 1 bis 4 oder 6 bis 9, dadurch gekennzeichnet, daß das Netzgerät mit seinen Schaltungskomponenten eine bauliche Einheit in Form einer in einen Verbraucher einbaubaren Schaltungsplatine ist.

15. Netzgerät nach Anspruch 13 oder 14, dadurch gekennzeichnet, daß die Baueinheit vergossen oder abgekapselt ist.

16. Netzgerät nach einem der Ansprüche 1 bis 6, dadurch gekennzeichnet, daß beim Trennen der Steckverbindung (22,18) zum Verbraucher (4) der Strom durch das Steuerelement (10) unterbrochen ist und der elektronische Schalter (5) im Primärkreis sperrt.

17. Netzgerät nach einem der vorhergehenden Ansprüche 4-16 zur Stromversorgung eines angeschlossenen Gerätes, das einen ersten Betriebszustand (Normalbetrieb) mit hoher Leistungsaufnahme und einen zweiten Betriebszustand (Standby-Betrieb) mit geringer Leistungsaufnahme aufweist, dadurch gekennzeichnet,
- daß ein Strommeßfühler im Gleichstromausgangszweig (9) vorgesehen ist, der mit einer Auswerteschaltung gekoppelt ist, die in Abhängigkeit von dem gemessenen niedrigen Strom im zweiten Betriebszustand eine Zeitschaltung ansteuert, die nach einer bestimmten vorgegebenen oder einstellbaren Zeit den Nebenschluß (16) automatisch öffnet.

18. Netzgerät nach einem der vorhergehenden Ansprüche, dadurch gekennzeichnet, daß die Ausgangsleitung (8) des Hilfsnetzteils (7) über das strom- und/oder spannungsabhängig arbeitende Steuerelement (10) mit der Potential führenden Leitung (9) auf der Sekundärseite des Transformators (2) des Netzgerätes verbunden ist.

19. Netzgerät nach einem der vorhergehenden Ansprüche, dadurch gekennzeichnet, daß parallel zu einem Siebkondensator (33) des Gleichrichters (32) ein Ohmscher Widerstand (40) und zwischen dem massefernen Ende dieses Widerstandes (40) und dem Ausgang (22) eine Diode (41) angeordnet ist, deren Kathode über einen Kondensator (42) mit Masse verbunden ist.

20. Netzgerät nach Anspruch 19, dadurch gekennzeichnet, daß alternativ oder zusätzlich zum Ohmschen Widerstand (40) ein parallel zum Kondensator (42) angeordneter weiterer Ohmscher Widerstand (40') vorgesehen ist.

## Claims

1. Mains apparatus, comprising a terminal (1) at a current supply mains, which conducts alternating voltage, with at least one transformer (2), a rectifier circuit (3) which is connected downstream and to which a load (4) is connectible, and an electronic switch (5) in the current feed line of the primary winding (6) of the transformer (2) and an auxiliary mains part (7) capacitively connected to the current feed line of the mains apparatus, characterised in that
- the auxiliary mains part (7) is a switching mains part (7) with a self-oscillating circuit,
- wherein a control voltage, which is higher than the voltage lying at the output of the mains apparatus under load, for the electronic switch (5) can be tapped at the output of the auxiliary mains part (7) and
- wherein the potential-conducting output line (8) of the auxiliary mains part is connected with the potential-conducting line (9) on the secondary side of the transformer (2) of the mains apparatus and
- current is taken from the auxiliary mains part (7) in the case of loading by a load (4), whereby a control element (10) operating in dependence on current and/or voltage generates a control signal for the electronic switch (5) in the current feed line of the primary winding (6) of the transformer (2) in the mains apparatus.

2. Mains apparatus according to claim 1, characterised in that a triac (11), together with a parallel exciting semiconductor (15), in series with the primary winding (12) of an auxiliary transformer (13) and an upstream capacitor (14) is provided as switching element of the self-oscillating circuit and is connected with one phase of the current supply mains, whilst the other end of the primary winding lies at the other phase.

3. Mains apparatus according to one of the preceding claims, characterised in that the connected load (4) loads the auxiliary mains part (7) in the connected and switched-on state with a current of specific strength for maintenance of the closed state of the switch (5).

4. Mains apparatus according to one of the preceding claims, characterised in that a high-resistance shunt (16) with a switching element (17) is provided between the outputs (18, 22), which conduct the potential and ground potential, at the secondary side.

5. Mains apparatus according to claim 4, characterised in that the switching element (17) is integrated in a connecting sleeve (18) for the coupling with the load (4) and switches in the resistance (16) in the shunt in the case of closing of the plug connection and switches out the resistance (16) in the shunt in the case of opening the plug connection.

6. Mains apparatus according to one of the preceding claims, characterised in that the auxiliary mains part (7) is capacitively connected in single phase with the current feed line of the mains apparatus.

7. Mains apparatus according to one of the preceding claims, characterised in that the auxiliary mains part (7) is a DC/DC converter and that a diode or diode arrangement for rectification of the mains voltage present or a divided mains voltage is connected in series with the capacitor (14).

8. Mains apparatus according to one of claims 1 to 6, characterised in that the auxiliary mains part (7) is an AC/DC converter.

9. Mains apparatus according to claim 7, characterised in that the auxiliary mains part (7) comprises a bridge rectifier, which is connected to the two phases of the current supply mains by way of two capacitors.

10. Mains apparatus according to claim 1, characterised in that the control element (10) is an opto-triac, wherein the current of the auxiliary mains part (7) at the secondary side flows by way of a luminescent diode (19), which controls the associated triac (34).

11. Mains apparatus according to claim 1, characterised in that the switch (5) is an electronic semiconductor switch.

12. Mains apparatus according to claims 10 and 11, characterised in that the switch (5) is a triac which is controlled by the opto-triac (10).

13. Mains apparatus according to one of the preceding claims, characterised in that the mains apparatus together with its circuit components is a constructional unit of a mains apparatus able to be plugged into a socket of a current supply apparatus.

14. Mains apparatus according to one of claims 1 to 4 or 6 to 9, characterised in that the mains apparatus together with its circuit components is a constructional unit in the form of a circuitboard able to be incorporated into a load.

15. Mains apparatus according to claim 13 or 14, characterised in that the constructional unit is cast around or encapsulated.

16. Mains apparatus according to one of claims 1 to 6, characterised in that on separation of the plug connection (22, 18) to the load (4) the current through the control element (10) is interrupted and the electronic switch (5) in the primary circuit blocks.

17. Mains apparatus according to one of the preceding claims 4 to 6 for the current supply of a connected apparatus, which has a first operational state (normal operation) with higher power consumption and a second operational state (standby operation) with lower power consumption, characterised in that a current measuring sensor is provided in the direct current output branch (9) and is coupled with an evaluating circuit which, in dependence on the measured low current, in the second operational state controls a timing circuit which automatically opens the shunt (16) after a specific preset or settable time.

18. Mains apparatus according to one of the preceding claims, characterised in that the output line (8) of the auxiliary mains part (7) is connected by way of the control element (10), which operates in dependence on current and/or voltage, with the potential-conducting line (9) on the secondary side of the transformer (2) of the mains apparatus.

19. Mains apparatus according to one of the preceding claims, characterised in that a resistive impedance (40) is arranged in parallel to a filter capacitor (23) of the rectifier (32) and a diode (41), the cathode of which is connected with ground by way of a capacitor (42), is arranged between the end, which is remote from ground, of this impedance (40) and the output (22).

20. Mains apparatus according to claim 19, characterised in that a further resistive impedance (40'), which is arranged in parallel to the capacitor (42), is provided alternatively or additionally to the resistive impedance (40).

## Revendications

1. Appareil de raccordement à un réseau, comprenant une borne (1) raccordée à un réseau d'alimentation en courant, qui applique une tension alternative, et comportant au moins un transformateur (2), un circuit redresseur (3) branché en aval, auquel peut être raccordé un appareil d'utilisation (4), et un interrupteur électronique (5) situé dans la ligne d'alimentation en courant de l'enroulement primaire (6) du transformateur (2) et une partie de réseau auxiliaire (7) raccordée de façon capacitive à la ligne d'alimentation en courant de l'appareil de raccordement au réseau, caractérisé en ce que
- la partie de réseau auxiliaire (7) est une partie de réseau commutée comportant un circuit auto-oscillant, et
- dans lequel à la sortie de la partie de réseau auxiliaire peut être prélevée une tension de commande pour l'interrupteur électronique (5), qui est supérieure à la tension appliquée sous charge à la sortie de l'appareil de raccordement au réseau, et
- la ligne de sortie (8), qui applique le potentiel, la partie de réseau auxiliaire, est reliée à la ligne (9), qui applique le potentiel, sur le côté secondaire du transformateur (2) de l'appareil de raccordement au réseau, et
- dans le cas de la sollicitation appliquée par un appareil d'utilisation (4), un courant est prélevé de la partie de réseau auxiliaire (7), ce qui a pour effet qu'un signal de commande pour l'interrupteur électronique (5) situé dans la ligne d'alimentation en courant de l'enroulement primaire (6) du transformateur (2) dans l'appareil de raccordement au réseau est produit.

2. Appareil de raccordement au réseau selon la revendication 1, caractérisé en ce qu'il est prévu, comme élément de commutation du circuit auto-oscillant, un triac (11) en parallèle avec lequel est branché un semiconducteur d'amorçage (15), qui est branché en série avec l'enroulement primaire (12) d'un transformateur auxiliaire (13) et comportant un condensateur (14) branché en amont et qui est relié à une phase d'alimentation en courant, tandis que l'autre extrémité de l'enroulement primaire est raccordée à l'autre phase.

3. Appareil de raccordement au réseau selon l'une des revendications précédentes, caractérisé en ce que l'appareil d'utilisation raccordé (4) charge la partie de réseau auxiliaire (7), dans l'état raccordé et branché, avec un courant d'une intensité déterminée pour le maintien de l'état fermé de l'interrupteur (5).

4. Appareil de raccordement au réseau selon l'une de revendications précédentes, caractérisé en ce qu'une dérivation de forte valeur ohmique (16) comportant un élément de commutation (17) est prévu entre les sorties situées côté secondaire et qui appliquent le potentiel et le potentiel de masse.

5. Appareil de raccordement au réseau selon la revendication 4, caractérisé en ce que l'élément de commutation (17) est intégré dans une douille de raccordement (18) pour le couplage à l'appareil d'utilisation (4) et, branche la résistance (16) en dérivation lors de la fermeture du connecteur, et la débranche lors de l'ouverture du connecteur.

6. Appareil de raccordement au réseau selon l'une des revendications précédentes, caractérisé en ce que la partie de réseau auxiliaire (7) est raccordée de façon capacitive et d'une manière monophasée à la ligne d'alimentation en courant de l'appareil de raccordement au réseau.

7. Appareil de raccordement au réseau selon l'une des revendications précédentes, caractérisé en ce que la partie de réseau auxiliaire (7) est un convertisseur continu-continu et qu'en série avec le condensateur (4) est branché une diode ou un dispositif de diodes servant à redresser la tension appliquée du réseau ou une tension divisée du réseau.

8. Appareil de raccordement au réseau selon l'une des revendications 1 à 6, caractérisé en ce que la partie de réseau auxiliaire (7) est un convertisseur alternatif-continu.

9. Appareil de raccordement au réseau selon la revendication 7, caractérisé en ce que la partie de réseau auxiliaire (7) comporte un redresseur en pont, qui est connecté aux deux phases du réseau d'alimentation en courant par l'intermédiaire de deux condensateurs.

10. Appareil de raccordement au réseau selon la revendication 1, caractérisé en ce que l'élément de commande (10) est un opto-triac, le courant côté secondaire de la partie de réseau auxiliaire (7), qui commande le triac associé (34), traversant une diode à luminescence (19).

11. Appareil de raccordement au réseau selon la revendication 1, caractérisé en ce que l'interrupteur (5) est un interrupteur électronique à semiconducteurs.

12. Appareil de raccordement au réseau selon les revendications 10 et 11, caractérisé en ce que l'interrupteur (5) est un triac, qui est commandé par l'opto-triac (10) .

13. Appareil de raccordement au réseau selon l'une des revendications précédentes, caractérisé en ce que l'appareil de raccordement au réseau. constitue, avec les composants de son circuit, une unité de construction d'un appareil de raccordement au réseau pouvant être enfiché dans une prise d'un réseau d'alimentation en courant.

14. Appareil de raccordement au réseau selon l'une des revendications 1 à 4 ou 6 à 9, caractérisé en ce que l'appareil de raccordement au réseau constitue, avec les composants de son circuit, une unité de construction sous la forme d'une platine de circuits pouvant être montée dans un appareil d'utilisation.

15. Appareil de raccordement au réseau selon la revendication 13 ou 14, caractérisé en ce que l'unité de construction est enrobée ou encapsulée.

16. Appareil de raccordement au réseau selon l'une des revendications 1 à 6, caractérisé en ce que, lors du retrait du connecteur (22,18) de l'appareil d'utilisation (4), le courant traversant l'élément de commande (10) est interrompu et l'interrupteur électronique (5) situé dans le circuit primaire est bloqué.

17. Appareil de raccordement au réseau selon l'une des revendications 4-16 pour l'alimentation en courant d'un appareil raccordé, qui comporte un premier état de fonctionnement (fonctionnement normal) avec une absorption élevée de puissance, et un second état de fonctionnement (état d'attente avec une faible absorption de puissance), caractérisé en ce
- qu'il est prévu, dans la branche de sortie à courant continu (9), un capteur de mesure du courant, qui est couplé à un circuit d'exploitation qui, en fonction du faible courant mesuré, dans le second état de fonctionnement, commande un circuit de temporisation qui ouvre automatiquement la dérivation (16) au bout d'un certain intervalle de temps prédéterminé ou réglable.

18. Appareil de raccordement au réseau selon l'une des revendications précédentes, caractérisé en ce que la ligne de sortie (8) de la partie de réseau auxiliaire (7) est reliée par l'intermédiaire de l'élément de commande (10) qui travaille en fonction du courant et/ou de la tension, à la ligne (9) appliquant le potentiel, sur le côté secondaire du transformateur (2) de l'appareil de raccordement au réseau.

19. Appareil de raccordement au réseau selon l'une des revendications précédentes, caractérisé en ce que la résistance ohmique (40) est disposée en parallèle avec un condensateur de lissage (33) du redresseur (32) et qu'entre l'extrémité, éloignée de la masse, de cette résistance (40) et la sortie (22) est disposée une diode (41) dont la cathode est reliée à la masse par l'intermédiaire d'un condensateur (42).

20. Appareil de raccordement au réseau selon la revendication 19, caractérisé en ce qu'à la place ou en plus de la résistance ohmique (40) il est prévu une autre résistance ohmique (40') disposée en parallèle avec le condensateur (42).
